Europäisches Patentamt

European Patent Office

Office européen des brevets

(19)

(11) EP 0 695 988 A2

## (12) EUROPEAN PATENT APPLICATION

(43) Date of publication:
07.02.1996 Bulletin 1996/06

(51) Int Cl.6: G06F 5/06

(21) Application number: 95305224.8

(22) Date of filing: 26.07.1995

(84) Designated Contracting States:
DE FR GB

(30) Priority: 05.08.1994 US 287333

(71) Applicant: AT&T Corp.
New York, NY 10013-2412 (US)

(72) Inventor: Baldwin, John H.
Morristown, New Jersey 07960 (US)

(74) Representative:
Buckley, Christopher Simon Thirsk et al
Woodford Green, Essex IG8 0TU (GB)

### (54) A first-in first-out memory

(57) A first-in first-out memory ("FIFO") that does not need dual-port memories can perform successive simultaneous read and write operations, without contention problems or the need to slow down either the source device or the destination device. Furthermore, the FIFO can use inexpensive commercially available memories to create large capacity FIFOs. A typical FIFO comprises: a control sequencer 201, a write-pointer 203, read-pointer 205, a first and second address generator 211, 213 and an output data driver 231.

FIG. 4

## Description

### Field of the Invention

The present invention relates to digital circuit design in general, and more particularly, to the design of a first-in first-out ("FIFO") memory.

### Background of the Invention

A communications system permits users to communicate over an extended distance and typically comprises a network of nodes and channels to make possible the communication. Although communications systems traditionally carry information in analog form, they are increasingly being built to carry messages in digital form.

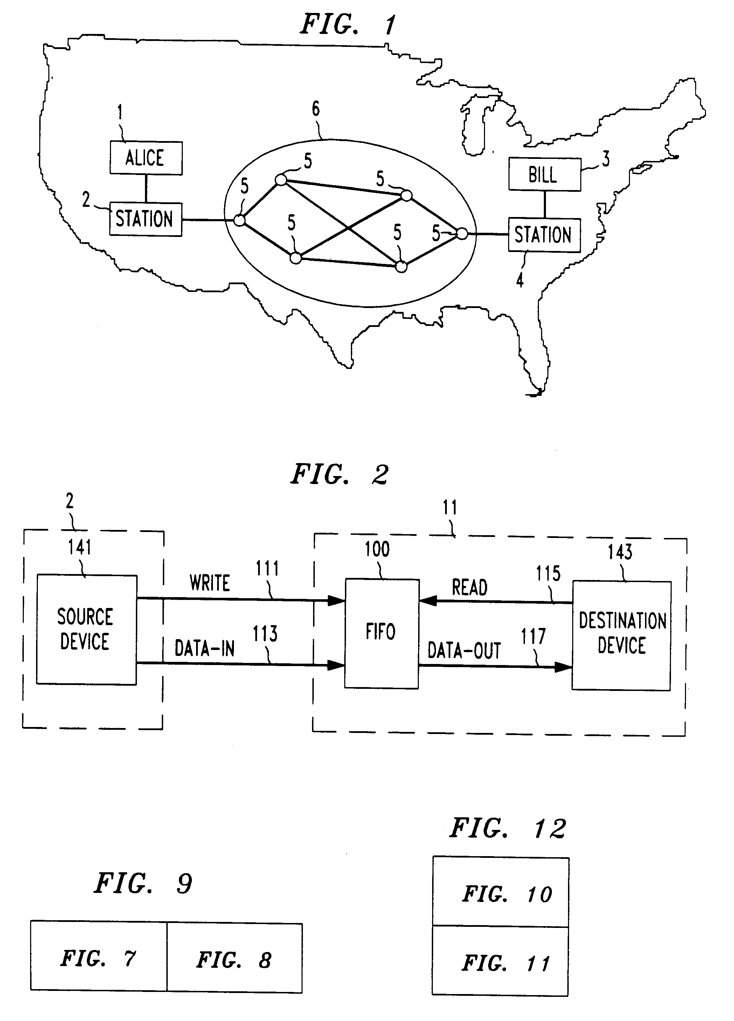

FIG. 1 presents a depiction of a digital communication system comprising a communications network 6 that enables two users, Alice 1 and Bill 3, to communicate. When Alice desires to transmit a message to Bill, she provides her station with the message. The station can be any device (e.g., a telephone, facsimile machine or computer) that is capable of transforming the message Alice provides into digital form. Typically, a message in digital form comprises a series of discrete datum. Alice's station then typically transmits the series of datum, one after another, to a node in the communications network. Often, the station transmits the series of datum to the network at a rate that is higher than the rate at which the network node can process the datum. In such cases, it is advantageous to incorporate into the network a temporal buffer to accommodate the disparity between the rate at which the individual datum arrive and the rate at which they can be processed. Such buffers are typically constructed from first-in first-out devices.

The principal characteristic of a first-in first-out device, commonly known as a "FIFO", is that it accepts multiple datum from a source device, stores the data, and then outputs them to a destination device in the same order that the datum were received.

### Summary of the Invention

Embodiments of the present invention avoid many of the costs and restrictions associated with first-in first-out memories ("FIFOs") in the prior art. Specifically, embodiments of the present invention can successively perform simultaneous read and write operations without contention problems or the need for dual-port random access memories ("RAMs"). Additionally, embodiments of the present invention are ideally suited for use in fabricating inexpensive large capacity FIFOs.

These results can be obtained in an illustrative embodiment of the present invention, which is attachable to two identical independent RAM banks, which embodiment advantageously comprises: a control sequencer, a write pointer, a read pointer, a first address generator for supplying a memory address to one of the two RAM banks, and a second address generator for supplying another memory address to the other of the two RAM banks.

### Brief Description of the Drawing

FIG. 1 depicts a drawing of a nationwide communications system, which can employ one or more embodiments of the present invention.

FIG. 2 is a block diagram of a data source device, a data destination device and a first-in first-out ("FIFO") memory, which is interposed between the first two devices.

FIG. 3 depicts a block diagram of the major components of the FIFO shown in FIG. 2.

FIG. 4 depicts a block diagram of the generic subcomponents of the FIFO RAM controller shown in FIG. 3.

FIG. 5 depicts a block diagram of the preferred embodiment of the FIFO RAM controller shown in FIG. 3.

FIG. 6 depicts an illustrative state-transition diagram for the control sequencer shown in FIGs. 4 and 5.

FIG. 7 is the first page of a schematic diagram of a finite-state machine implementation of the state-transition diagram of FIG. 6.

FIG. 8 is the second page of a schematic diagram of a finite-state machine implementation of the state-transition diagram of FIG. 6.

FIG. 9 is an illustration that indicates how FIGs. 7 and 8 relate to form a single schematic drawing.

FIG. 10 shows the first page of a timing diagram that illustrates the interrelationships of the various signals in the preferred embodiment as the preferred embodiment undergoes a typical exercise.

FIG. 11 shows the second page of a timing diagram that illustrates the interrelationships of the various signals in the preferred embodiment as the preferred embodiment undergoes a typical exercise.

FIG. 12 is an illustration that indicates how FIGs. 10 and 11 relate to form a single timing diagram.

## Detailed Description

FIG. 2 depicts a block diagram of the preferred embodiment of the present invention, which functions as a first-in first-out memory ("FIFO") with a capacity of N M-bit pieces of data. For the purposes of this specification, N defines the depth of the FIFO and M defines the width of the FIFO. Embodiments of the present invention are particularly well-suited for deep (*i.e.*, large N) FIFOs and avoid the necessity of using dual-port RAMs (*i.e.*, RAMs that can perform two simultaneous reads, two simultaneous writes, or a simultaneous read and write to two different memory locations). Dual-port RAMs are typically disadvantageous in that they tend to have less capacity than single-port RAMs of the same price.

Furthermore, while it will be clear to those skilled in the art that embodiments of the present invention can be fabricated on a single integrated circuit, FIFOs using the present invention can be fabricated from multiple integrated circuits as well. Such implementations offer the potential for inexpensive, very large capacity FIFOs, as are desirable in Asynchronous Transfer Mode ("ATM") networks.

As shown in FIG. 2, it is preferred that FIFO 100 is a synchronous device whose clock is synchronized with source device 141 and destination device 143, which transmit a datum or receive a datum from FIFO 100, respectively. It will be clear to those skilled in the art from the foregoing discussion how to make and use embodiments of the present invention that are asynchronous relative to source device 141 and/or destination device 143.

The operation of the preferred embodiment, with respect to source device 141 and destination device 143, will now be described. FIFO 100 preferably accepts as input a binary write signal on lead 111 and a binary read signal on lead 115. For the purposes of this specification a binary signal is defined as a signal that can have only one of two possible values: "asserted" (alternately called, or shown in the figures as, "HIGH" or "1") and "retracted" (alternately called, or shown in the figures as, "LOW" or "0"). In the illustrative embodiment both the write signal and the read signal are active HIGH.

When source device 141 desires to transmit a datum to FIFO 100, source device 141 preferably puts the datum on data-in bus 113 and asserts the write signal on lead 111 for one-clock cycle, in well-known fashion. Analogously, when source device 141 does not desire to transmit a datum, source device 141 preferably retracts the write signal on lead 111, in which case the spurious signals on data-in bus 113 are ignored by FIFO 100.

When destination device 143 desires to receive a datum from FIFO 100, destination device 143 preferably asserts the read signal on lead 115, in which case FIFO 100 transmits the appropriate datum to destination device 141 on data-out bus 117 in the next clock cycle, again in well-known fashion. Analogously, when destination device 143 does not desire a datum from FIFO 100, destination device 143 preferably retracts the read signal on lead 115 and ignores the spurious signals on data-out bus 117.

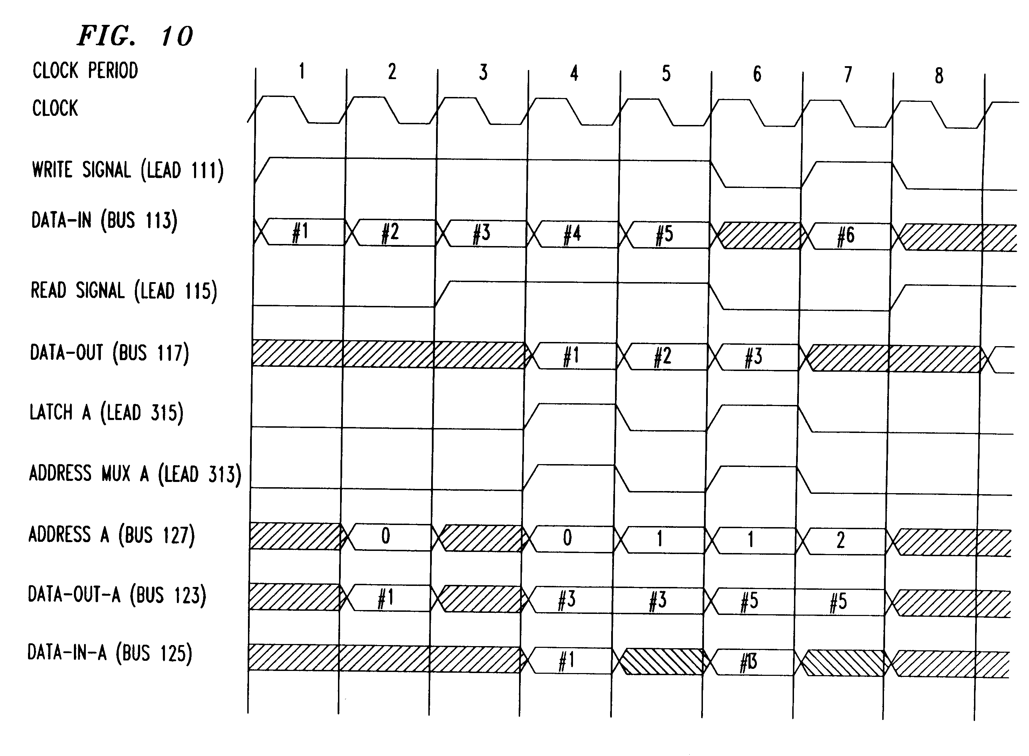

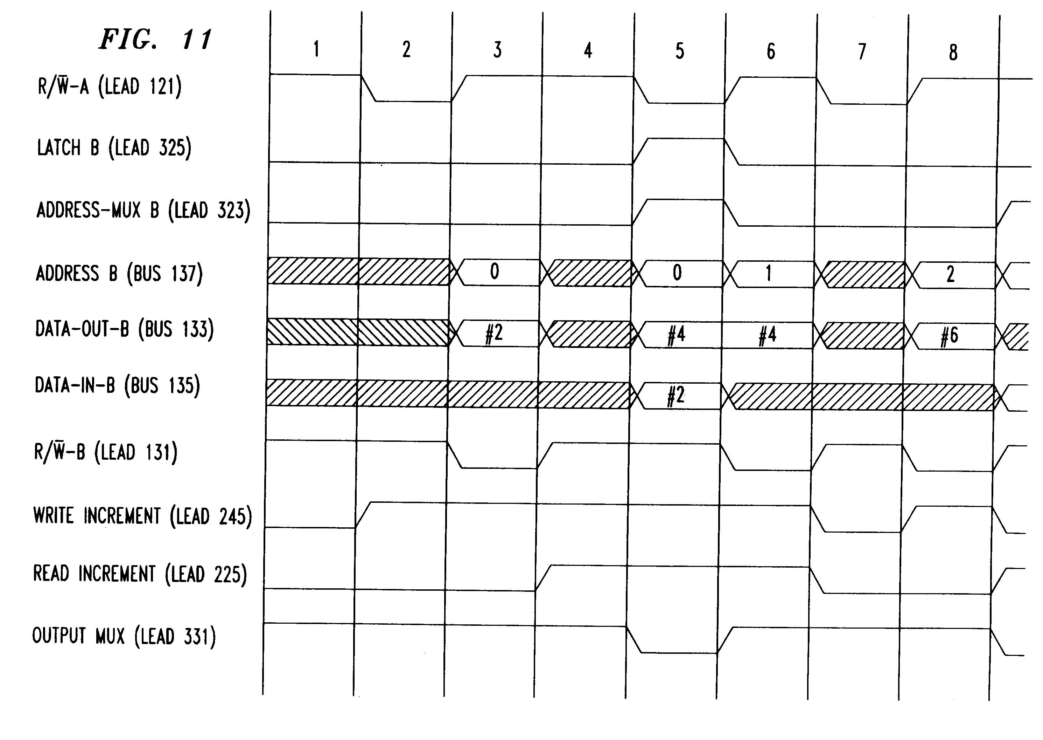

In the preferred embodiment, FIFO 100 is advantageously capable of successively simultaneously receiving one datum from source device 141 and transmitting another datum to destination device 143, without requiring either source device 141 or destination device 143 to wait. The relative timing of the write signal, the read signal, and the datum on data-in bus 113 and data-out bus 117 is shown in FIG. 10, 11 and 12, and will be discussed at length below.

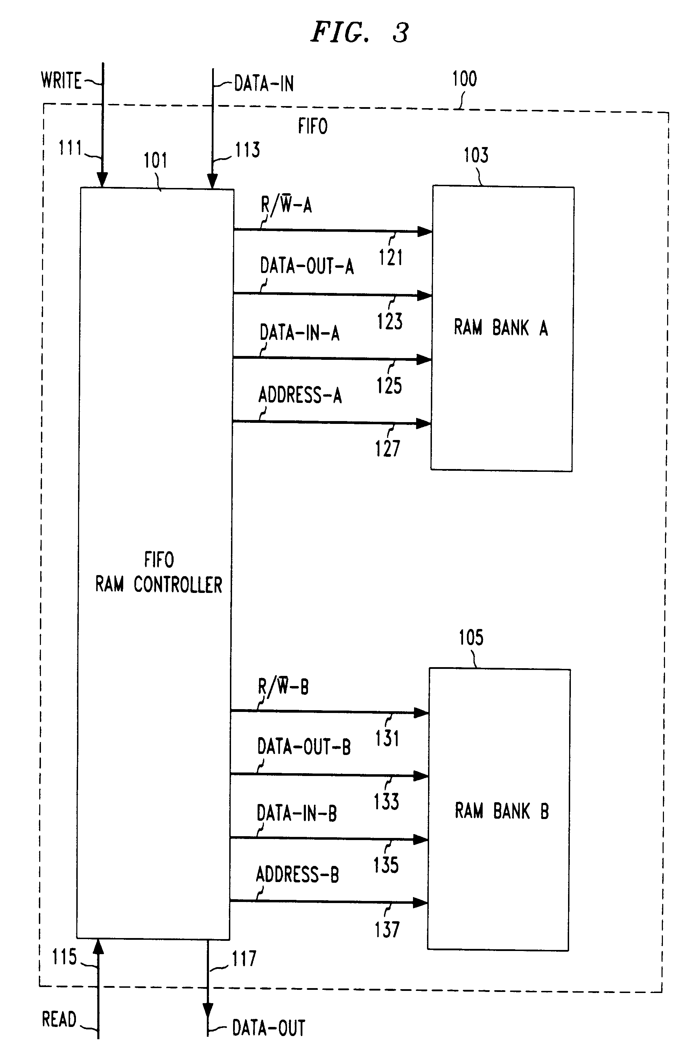

FIG. 3 depicts a block diagram of the major components of FIFO 100: FIFO RAM controller 101, RAM Bank A 103 and RAM Bank B 105, interconnected as shown. The composition and operation of FIFO RAM controller 101 will be discussed below. Both RAM Bank A 103 and RAM RAM Bank B 105 are preferably identical

$$\frac{N}{2}$$

M-bit random access memories with separate data-in and data-out ports, although it will be clear to those skilled in the art how to fabricate embodiments of the invention with other types of memories, including single port RAMs. For the purposes of this specification the read and write controls of both RAM Bank A 103 and RAM Bank B 105 are each controlled by a R/W signal on leads 121 and 131, respectively, which are defined to indicate a read when the respective signal is asserted and a write when the signal is retracted. As will be clear to those skilled in the art, FIFO RAM controller 101 advantageously communicates with both RAM Bank A 103 and RAM Bank B 105 independently, in well-known fashion.

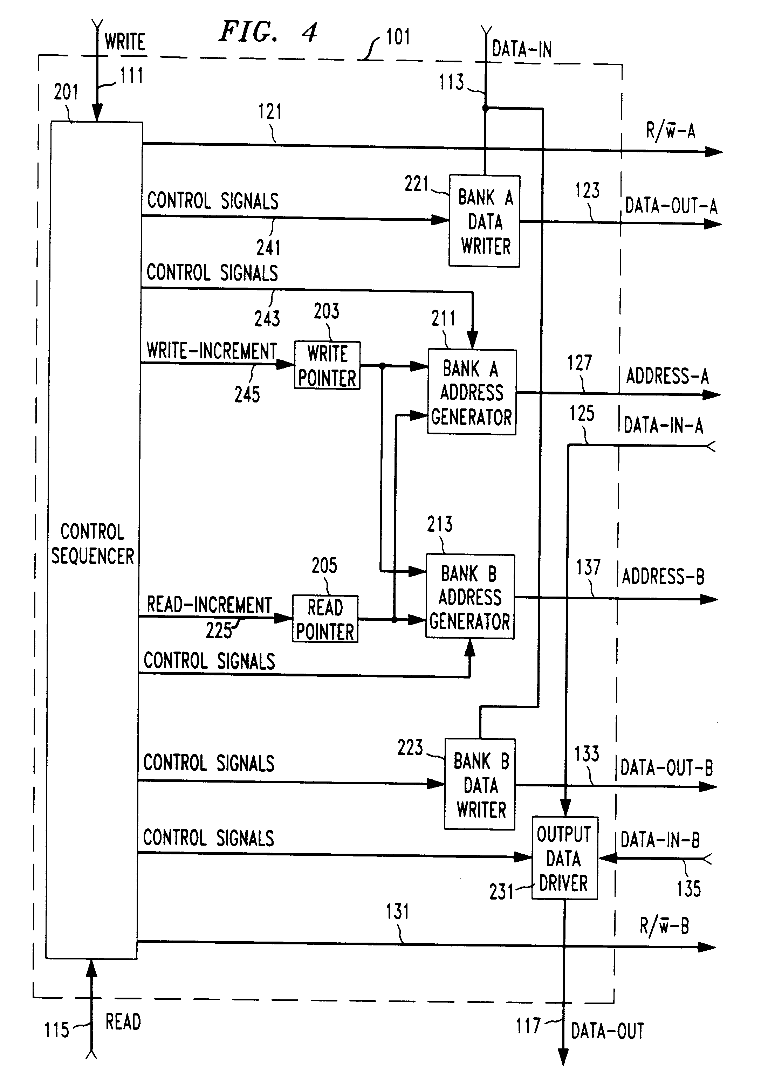

FIG. 4 depicts a block diagram of the eight generic constituents composing the illustrative embodiment of FIFO RAM controller 101. Control sequencer 201 is preferably a synchronous finite-state machine that receives as input the read signal on lead 115 and the write signal on lead 111. Control sequencer 201 controls, via various control signals, the R/W signal to both RAM Bank A 103 and RAM Bank B 105, write-pointer 203, read-pointer 205, RAM Bank A address generator 211, RAM Bank B address generator 213, RAM Bank A data writer 221, RAM Bank B data writer 223 and output data driver 231.

As will be clear to those skilled in the art, the internal operation of FIFO 100 can be conceptualized as a circular queue. The back of the queue is where successive datum are written to and is preferably pointed to by a logical pointer contained in write-pointer 203. The front of the queue is where successive datum are read from and is preferably pointed to by a logical pointer contained in read-pointer 205. The queue is preferably fabricated from two independent RAM banks, whose physical addresses are logically mapped so that successive positions in the conceptual circular queue are physically contained in different RAM banks.

For example, if RAM Bank A 103 has a capacity of 4 datum, and RAM RAM Bank B 105 has a capacity of 4 datum, then FIFO 100 has a total capacity of 8 datum. If FIFO 100 has a capacity of 8 datum, then the conceptual circular queue has a maximum of 8 storage positions, with logical addresses 0, 1, 2, 3, 4, 5, 6 and 7. In such case it is preferred that logical addresses 0, 2, 4, and 6 be assigned to RAM RAM Bank A 103 physical addresses 0, 1, 2, and 3, respectively, and that logical addresses 1, 3, 5, and 7 be assigned to RAM Bank B 105 physical addresses 0, 1, 2, and 3, respectively.

It is essential to understand that in the preferred embodiment, write-pointer 203 and read-pointer 205 point to logical positions in the conceptual circular queue and not to physical memory locations in either RAM Bank A 103 or RAM Bank B 105. It is preferred that both write-pointer 203 and read-pointer 205 be fabricated from $\log_2 N$ counters that count from 0 to N - 1 and then roll-over to 0. In such case, the mapping of logical queue positions to physical memory addresses can be accomplished by using all but the least significant bit from each pointer as the full physical address into the respective RAM bank. In other words, the physical address is equal to the greatest integer contained in dividing the logical address by two. The advantage in this scheme is that the respective RAM bank to which the physical address can be determined by examining the least significant bit in the logical address (e.g., "0" = RAM Bank A, "1" = RAM Bank B).

Because the logical address pointed to by read-pointer 205 is independent of that pointed to by write-pointer 203, occasions can occur when both read-pointer 205 and write-pointer 203 will both point into the same RAM bank. And because, in the preferred embodiment, one RAM bank cannot be both simultaneously written to and read from, a mechanism is advantageously used to resolve the contention. That mechanism preferably comprises RAM Bank A address generator 211 and RAM Bank B address generator 213, which are both controlled by control sequencer 201, independently of each other. From the following discussion it will be clear to those skilled in the art how to make and use RAM Bank A address generator 211 and RAM Bank B address generator 213.

In the preferred embodiment, when it is initially desired that both a write and a read be simultaneously performed with respect to a single RAM bank, the read is given priority by the respective bank address generator and the address of the write is stored until the read is performed, when the write is then performed. Furthermore, either RAM Bank A data writer 221 or RAM Bank B data writer 223, as appropriately preferably stores the newly arriving datum to be written until the read is performed and the write can be written.

Conversely, it will be clear to those skilled in the art how to build and use embodiments of the present invention which prioritize the write operation and delay the read. In that case, it will be clear to those skilled in the art that RAM Bank A data writer 221 and RAM Bank B data writer 223 can be eliminated. Output data driver 231 receives data from both RAM Bank A 103 and RAM RAM Bank B 105 and, under the guidance of control sequencer 201, directs the appropriate datum onto data-out bus 117. It will be clear to those skilled in the art how to fabricate output data driver 231 for designs that are write prioritized, instead of read prioritized as is the preferred embodiment.

It will be clear to those skilled in the art that this particular embodiment incorporates a latency of one clock cycle between when a datum is written to FIFO 100 and when the datum is available to be read from FIFO 100. It will be clear to those skilled in the art how to make and use embodiments of the present invention which have either no latency or a latency of greater than one clock cycle.

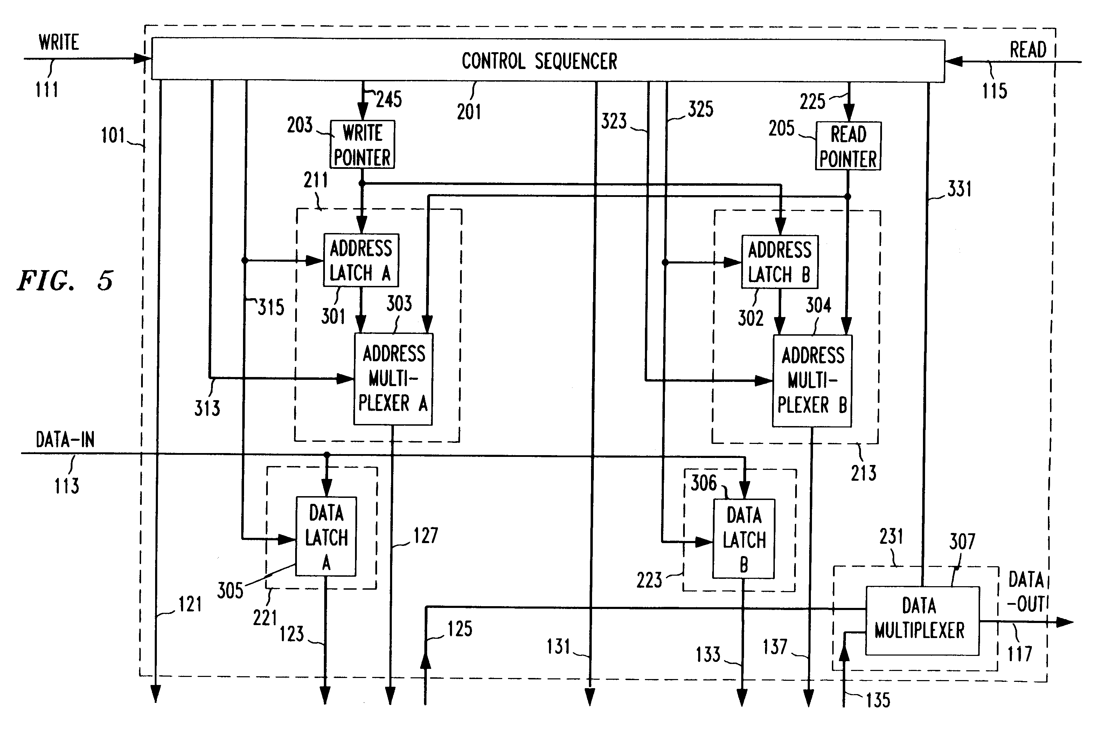

FIG. 5 depicts a schematic diagram of the preferred embodiment of the present invention, which conforms to the preferred generic architecture depicted in FIG. 4. The preferred embodiment comprises control sequencer 201, write-pointer 203, read-pointer 205, address latch A 301, address multiplexor A 303, data latch A 305, address latch B 302, address multiplexor B 304, data latch B 306 and data multiplexor 307. It should be clear that in this embodiment, address latch A 301 and address multiplexor A 303 compose RAM Bank A address generator 211 and that address latch B 302 and address multiplexor B 304 compose RAM Bank B address generator 213. Furthermore, data latch A 305 composes RAM Bank A data writer 221, data latch B 306 composes RAM Bank B data writer 223, and data multiplexor 307 composes output data driver 231.

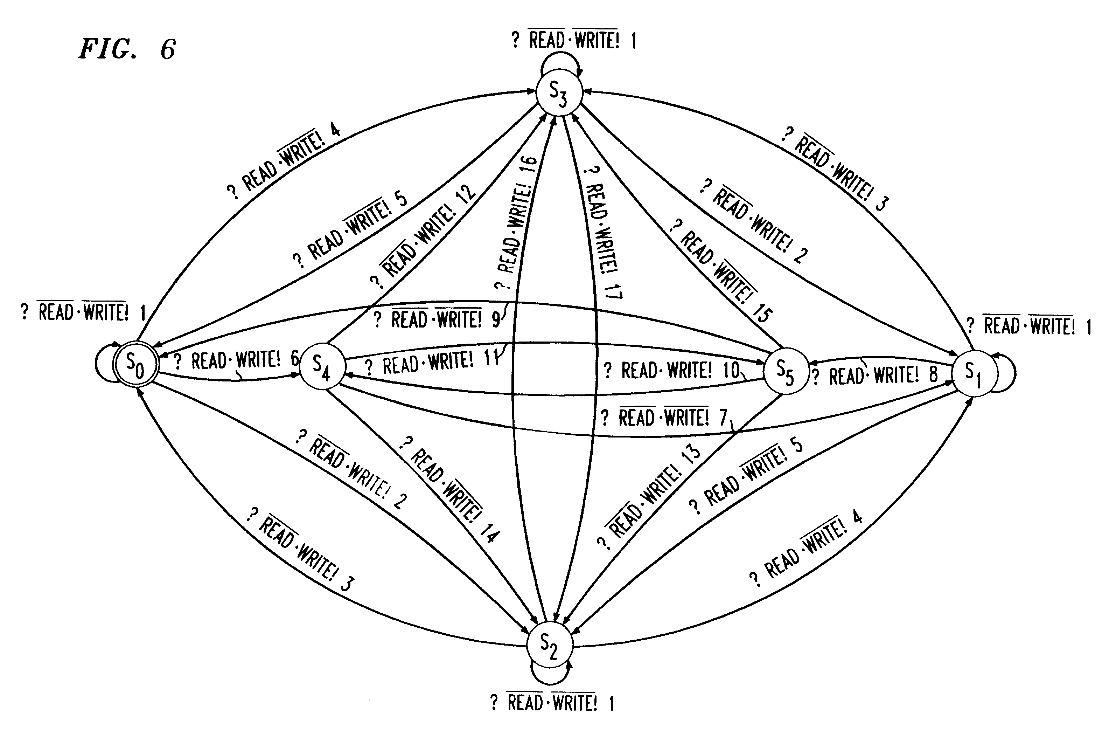

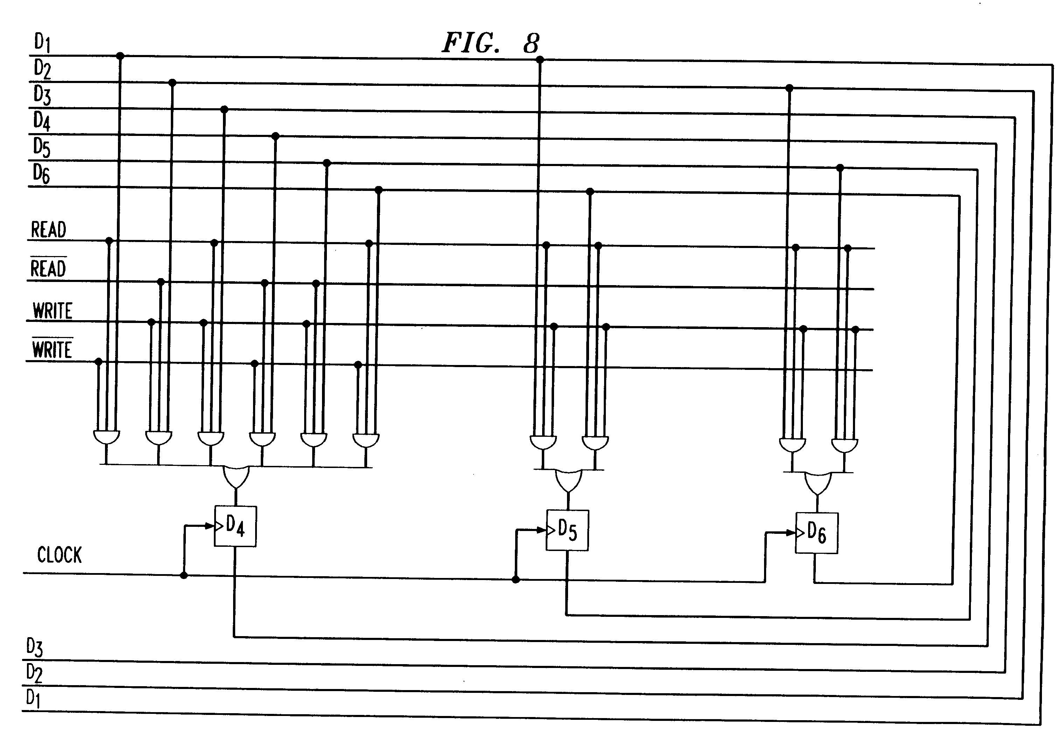

Control sequencer 201 is preferably implemented according to the state-transition diagram depicted in FIG. 6. As shown in FIGS. 6, 7, 8, and 9 control sequencer 201 is preferably a finite-state machine that has at least six mutually exclusive states, and which preferably receives as input the binary read signal and the binary write signal. As shown in FIG. 6, the initial state of the state-transition diagram, and correspondingly the finite state machine is state $s_0$.

| State | Write-Pointer 203 | Read-Pointer 205 | Access Latch 301 | Address Latch 302 |
|---|---|---|---|---|
| | points to | points to | contains | contains |
| $s_0$ | RAM Bank A | RAM Bank A | nothing | nothing |
| $s_1$ | RAM Bank B | RAM Bank B | nothing | nothing |
| $s_2$ | RAM Bank B | RAM Bank A | nothing | nothing |

(continued)

| State | Write-Pointer 203 | Read-Pointer 205 | Access Latch 301 | Address Latch 302 |
|---|---|---|---|---|
| | points to | points to | contains | contains |
| $s_3$ | RAM Bank A | RAM Bank B | nothing | nothing |
| $s_4$ | RAM Bank B | RAM Bank B | next write address | nothing |
| $s_5$ | RAM Bank A | RAM Bank A | nothing | next write address |

Table 1 - Preferred Definition of Control Sequencer States in Terms of Write-Pointer 203, Read-Pointer 205 and the contents of Address Latch A 301 and Address Latch B 302.

The states are advantageously defined in terms of which physical RAM bank each pointer's logical address translates into and the contents of the address latches, as shown in Table 1. It will be clear to those skilled in the art how to make and use embodiments of the present invention that have more inputs (e.g., a reset signal) to the control sequencer or more states in the control sequencer.

The finite-state machine of FIG. 6 is depicted as a directed graph ($V, E$) where $V$ is the set of states in the machine (e.g., $s_0$, ... $s_5$) and $E$ is the set of edges or transitions between the respective states. Each state in FIG. 6 is represented by a circle that encircles the designation of the state. Each edge is labeled by an I/O operation that both defines the conditions necessary for the transition to occur and the actions to be taken as a result of the transition.

For notational purposes, each edge is labeled by a text string of the format ?a·b!1, which denotes that the edge is to be traversed when both inputs a and b are true. Furthermore, when the edge is traversed, the state machine is to affect the actions that correspond to the action number following the exclamation mark. For example, an edge labeled as ?READ·WRITE!6 is to be traversed when both the read signal and the write signal are asserted. Furthermore, the traversal of that edge triggers action number 6. Table 2 defines each of the 17 different actions, designated in FIG. 6 in terms of the effect each has on the control signals shown in the schematic of FIG. 5.

| Action | 1 | 2 | 3 | 4 | 5 | 6 | 7 | 8 | 9 | 10 | 11 | 12 | 13 | 14 | 15 | 16 | 17 |
|---|---|---|---|---|---|---|---|---|---|---|---|---|---|---|---|---|---|
| Read Increment (225) | N | N | N | Y | Y | Y | N | Y | N | Y | Y | N | N | Y | Y | Y | Y |
| Write Increment (245) | N | Y | Y | N | N | Y | N | Y | N | Y | Y | Y | Y | N | N | Y | Y |
| Address Mux A (313) | x | W | x | R | x | R | W | x | x | R | W | W | W | W | R | R | W |
| Latch A (315) | E | E | E | E | E | L | E | E | E | L | E | E | E | E | E | E | E |
| R/W A (121) | R | W | R | R | R | R | W | R | R | R | W | W | W | W | R | R | W |
| Address Mux B (323) | x | x | W | x | R | x | x | R | W | W | R | W | W | R | W | W | R |
| Latch B (325) | E | E | E | E | E | E | E | L | E | E | L | E | E | E | E | E | E |
| R/W B (131) | R | R | W | R | R | R | R | R | W | W | R | W | W | R | W | W | R |
| Output Mux (331) | x | x | x | A | B | A | x | B | x | A | B | x | x | B | A | A | B |

Table 2 - Latched-Write Configuration Action Tables

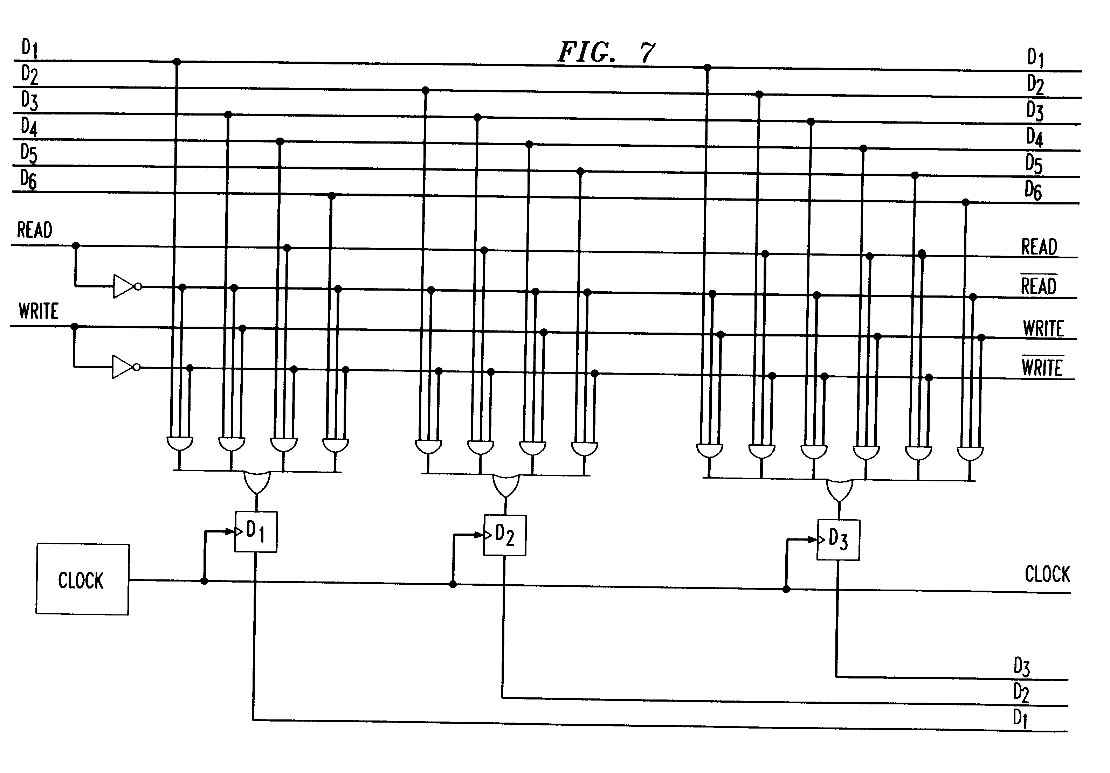

It will be clear to those skilled in the art how to build control sequencer 201 from FIG. 6 and Table 2. FIGs. 7, 8 and 9 depict a schematic diagram of an illustrative control sequencer 201 that corresponds to the finite-state machine in FIG. 6. For pedagogical purposes, the illustrative control sequencer 201 is shown designed from AND gates, OR gates, inverters and "D"-type flip-flops. It will be clear those skilled in the art how to build control sequencer 201 with other components.

Referring back to FIG. 5, write-pointer 203 is preferably a $\log_2 N$ bit synchronous counter whose counting is controlled by the write-increment signal on lead 245. When the write-increment signal is asserted by control sequencer 201, write-pointer 203 increments once after the next clock pulse. When the write-increment signal is retracted, write-pointer 203 does not increment. Read-pointer 205 is preferably of the same design as write-pointer 203, except that it is controlled by the read-increment signal on lead 225.

The output of write-pointer 203 is fed into address latch A 301 and address latch 302, which are both preferably $\log_2 \frac{N}{2}$ bit wide latches. When the latch A signal on lead 315 is asserted, address latch A 301 is put into latch enable mode whereby any signals at its input are synchronously latched to its output in the next clock cycle. When the latch A signal on lead 315 is retracted, address latch 301 acts as a latch and holds whatever signals that were latched. In such case, address latch A 301 outputs its stored value regardless of changes to its input. Address latch 302 is preferably of the same design as address address latch A 301, except that it is controlled by the latch B signal on lead 325.

Address multiplexor A 303 is preferably a $\log_2 \frac{N}{2}$ bit wide two-to-one multiplexor and is fed the output of write-pointer 203, via address address latch A 301, and read-pointer 205. Address multiplexor A 303 is controlled by the address-mux-A signal on lead 313. Address multiplexor B 304 is preferably of the same design as address multiplexor A 303, except that it is controlled by the address-mux-B signal on lead 323.

Data latch A 305 is advantageously an M-bit wide latch that is controlled by the latch A signal on lead 315. The design and operation, although not necessarily the width, of data latch A 305 and data latch B 306 are preferably similar to that of address address latch A 301 and address latch B 302. Data latch B 306 is preferably of the same design as data latch A 305, except that it is controlled by the latch B signal on lead 325.

Data multiplexor 307 is preferably a M bit wide two-to-one multiplexor that is controlled by the output mux signal on lead 331. The design and operation, although not necessarily the width, of data multiplexor 307 is advantageously similar to that of address multiplexor A 303 and address multiplexor 304. From the foregoing it will be clear to those skilled in the art how to make and use embodiments of the present invention.

The operation of the preferred embodiment can be readily seen from the timing diagram shown in FIGs. 10, 11 and 12. Prior to clock period 1, the embodiment is defined to be in its initial state, $s_0$. Also, write-pointer 203 and read-pointer 205 are both set to zero.

In clock period 1, the write signal (on lead 111) is asserted and datum #1 is placed on data-in bus 113, by source device 141. Simultaneously, the read signal (on lead 115) is retracted, indicating that destination device 143 does not desire a datum at this point in time. Because the read signal is retracted and the write signal is asserted at the beginning of clock period 2, the embodiment progresses into state $s_2$ (as can be gleaned from FIG. 6 or FIGs. 7, 8 and 9). The transition from state $s_0$ to state $s_2$ triggers action #2, which causes control sequencer 201 to affect the control signals, as defined in Table 2.

During clock period 2, this causes: (1) the write-pointer to put address 0 through latch A and address-mux-A onto address-A bus 127; (2) datum #1 to be put onto data-out-A bus 123; (3) the R/W-A signal (on lead 121) to be retracted; (4) datum #1 to be written into RAM Bank A at address 0; and (5) the write-pointer to be incremented.

Also during clock period 2, the write signal remains asserted and datum #2 is placed on data-in bus 113, by source device 141. The read signal on lead 115 remains retracted. Therefore, because the embodiment is in state $s_2$, and the read signal is retracted while the write signal is asserted, the embodiment progresses back into state $s_0$. This transition causes control sequencer 201 to take action #3, as defined in Table 2, during clock period 3.

During clock period 3, this causes: (1) the write-pointer to put address 0 through address latch B and address-multiplexor-B and onto address-B bus 137; (2) datum #2 to be put onto data-out-B bus 133; (3) the R/W-B signal (on lead 131) to be retracted; (4) datum #2 to be written into RAM Bank B at physical address 0; and (5) the write-pointer to be incremented.

Also during clock period 3, the write signal remains asserted and datum #3 is placed on data-in bus 113. Furthermore, the read signal on lead 115 becomes asserted, indicating that destination device 143 desires a datum. Because during clock period 3 the embodiment is in state $s_0$, and both the read signal and the write signal are asserted, the embodiment progresses into state $s_4$. This transition causes control sequencer 201 to take action #6, as defined in Table 2, in clock period 4.

During clock period 4, this causes two major activities to happen. First, the reading of datum #1 from RAM Bank A occurs and datum #1 is output onto data-out bus 117. Second, because the read operation dominates RAM Bank A, and thus prevents the writing of datum #3 into RAM Bank A, datum #3 is stored in data latch A 305 and the RAM Bank A address where datum #3 is to be stored is stored in address latch A 301, until the next clock period when the write can be completed.

More specifically, during clock period 4, this causes: (1) the read-pointer to put address 0 through address-multiplexor-A 303 and onto address-A bus 127; (2) the R/W-A signal (on lead 121) to be asserted; (3) datum #1 to read out of RAM Bank A on data-in bus 125 and through data multiplexor 307 onto data-out bus 117; (4) address latch A 301 to latch address 1; (5) data latch A 305 to latch datum #3; (6) the write-pointer to be incremented; and (7) the read-pointer to be incremented.

Also during clock period 4, the write signal remains asserted and datum #4 is placed on data-in bus 113. Furthermore, the read signal also remains asserted, indicating that destination device 143 desires another datum. Because during clock period 4 the embodiment is in state $s_4$, and both the read signal and the write signal are asserted, the embodiment progresses into state $s_5$. This transition causes control sequencer 201 to take action #11, as defined in Table 2, during clock period 5.

During clock period 5, this causes three major activities to happen. First, datum #2 is read from RAM Bank B and output onto data-out bus 117. Second, datum #3 is written into RAM Bank A from latch A. And third, because the read operation dominates RAM Bank B, and thus prevents the writing of datum #4 into RAM Bank B, datum #4 is stored in data latch B 306 and the RAM Bank B address where datum #4 is to be stored is stored in address latch B 302, until the next clock period when the write can be completed.

More specifically, during clock period 5, this causes: (1) the read-pointer to put address 0 through address-multiplexor-B 304 and onto address-B bus 137; (2) the R/W-B signal (on lead 131) to be asserted; (3) datum #2 to be read out of RAM Bank B on data-in bus 135 and through data multiplexor 307 onto data-out bus 117; (4) address latch A 301 to put address 1 through address multiplexor-A and onto address-A bus 127; (5) the R/W-A signal (on lead 121) to be retracted; (6) datum #3 to stored in RAM Bank A at address 1; (7) address latch B 302 to latch address 1 from write-pointer 203; (8) data latch B 306 to latch datum #4; (9) the read-pointer to be incremented; and (10) the write-pointer to be incremented.

Also during clock period 5, the write signal remains asserted and datum #5 is placed on data-in bus 113. Furthermore, the read signal also remains asserted, indicating that destination device 143 desires another datum. Because during clock period 5 the embodiment is in state $s_5$, and both the read signal and the write signal are asserted, the embodiment returns to state $s_4$. This transition causes control sequencer 201 to take action #10, as defined in Table 2, during clock period 6.

During clock period 6, this causes three major activities to happen. First, datum #3 is read from RAM Bank A and output onto data-out bus 117. Second, datum #4 is written into RAM Bank B from data latch B. And third, because the read operation dominates RAM Bank A, and thus prevents the writing of datum #5 into RAM Bank A, datum #5 is stored in data latch A 305 and the RAM Bank A address where datum #5 is to be stored is stored in address latch A 301, until the next clock period when the write can be completed.

More specifically, during clock period 6, this causes: (1) the read-pointer to put address 1 through address-multiplexor-A 303 and onto address-A bus 127; (2) the R/W-A signal (on lead 121) to be asserted; (3) datum #3 to be read out of RAM Bank A on data-in bus 125 and through data multiplexor 307 onto data-out bus 117; (4) address latch B 302 to put address 1 through address multiplexor-B and onto address-B bus 137; (5) the R/W-B signal (on lead 131) to be retracted; (6) datum #4 to stored in RAM Bank B at address 1; (7) address latch A 301 to latch address 2 from write-pointer 203; (8) data latch A 305 to latch datum #5; (9) the read-pointer to be incremented; and (10) the write-pointer to be incremented.

Also during clock period 6, both the write signal and the read signal are retracted. Because during clock period 6 the embodiment is in state $s_4$, and both the read signal and the write signal are retracted, the embodiment progresses to state $s_1$. This transition causes control sequencer 201 to take action #7, as defined in Table 2, during clock period 7.

During clock period 7, the inchoate writing of datum #5 is completed. Specifically, during clock period 7, this causes: (1) latch A 301 to put address 2 through address multiplexor-A and onto address-A bus 127; (2) the R/W-A signal (on lead 121) to be retracted; and (3) datum #5 to stored in RAM Bank A at address 2.

Also during clock period 7, the write signal is again asserted and datum #6 is placed on data-in bus 113, by source device 141. The read signal on lead 115 remains retracted. Therefore, because the embodiment is in state $s_1$, and the read signal is retracted while the write signal is asserted, the embodiment progresses into state $s_3$. This transition causes control sequencer 201 to take action #3, as defined in Table 2, during clock period 8.

During clock period 8, this causes: (1) the write-pointer to put address 2 through address latch B 302 and address-multiplexor-B 304 and onto address-B bus 137; (2) datum #6 to be put onto data-out-B bus 133; (3) the R/W-B signal (on lead 131) to be retracted; (4) datum #6 to be written into RAM Bank B at address 2; and (5) the write-pointer to be incremented.

Also during clock period 8, the write signal is retracted and the read signal becomes asserted. Because during clock period 8 the embodiment is in state $s_3$, and the read signal is asserted which the write signal are retracted, the embodiment returns to state $s_0$. This transition causes control sequencer 201 to take action #5, as defined in Table 2, during clock period 9, and the process repeats indefinitely.

While there are no error signals incorporated into the preferred embodiment, it will be clear to those skilled in the art how to make and use embodiments of the present invention that incorporate them.

**Claims**

1. An apparatus (101), CHARACTERIZED IN THAT said aparatus is attachable to a first memory (103) and a second memory (105), and comprises:

    a control sequencer (201) for receiving a write signal and a read signal, and for generating a plurality of control signals;

    a write pointer (203);

    a read pointer (205);

    a first address generator (211) for supplying a first address to said first memory (103), which first address is based on said write pointer, said read pointer and at least one of said control signals; and

    a second address generator (213) for supplying a second address to said second memory (105), which second address is based on said write pointer, said read pointer and at least one of said control signals.

2. The apparatus of claim 1 further comprising an output data driver (231) for reading a first datum from said first memory (103) and a second datum from said second memory (105), and for selectively outputting one of said first datum and said second datum based on at least one of said control signals.

3. The apparatus of claim 1 further comprising:

    a first data writer (221) for receiving a first datum from a data bus (113) and for writing said first datum to said first memory (103); and

    a second data writer (223) for receiving a second datum from said data bus (113) and for writing said second datum to said second memory (105).

4. The apparatus of claim 1 wherein:

    said first address generator (211) comprises:

    (1) a first latch (301) connected to said write pointer (203), and

    (2) a first multiplexor (303) connected to said first latch (301) and said read pointer (205); and

    said second address generator (213) comprises:

    (1) a second latch (302) connected to said write pointer (203), and

    (2) a second multiplexor (304) connected to said second latch (302) and said read pointer (205).

5. A first-in first-out memory (100) comprising:

    a first memory (103);

    a write pointer (203);

    a read pointer (205);

    CHARACTERIZED BY:

    a second memory (105);

    a control sequencer (201) for receiving a write signal and a read signal and for generating a plurality of control signals;

    a first address generator (211) for supplying an address to said first memory based on said write pointer, said read pointer and at least one of said control signals; and

    a second address generator (213) for supplying an address to said second memory based on said write pointer, said read pointer and at least one of said control signals.

6. The apparatus of claim 5 further comprising:

    a first data writer (221) for writing data to said first memory; and

    a second data writer (223) for writing data to said second memory;

7. The apparatus of claim 5 further comprising:

    an output data driver (231) for reading data from said first memory and said second memory, and for outputting a datum based on at least one of said control signals.

8. The apparatus of claim 1 or 5 wherein said first memory is a random access memory and said second memory is a random access memory.

9. An apparatus (101) comprising:
a control sequencer (201) for receiving a write signal and a read signal and for generating a plurality of control signals;
a write pointer (203) for holding a first memory address;
a read pointer (205) for holding a second memory address;
CHARACTERIZED BY:
said apparatus being attachable to a first memory (103) and a second memory (105);
a first address generator (211) for supplying a third address to said first memory based on said first memory address, said second memory address and at least one of said control signals;
a second address generator (213) for supplying a fourth address to said second memory based on said first memory address, said second memory address and at least one of said control signals;
a first data writer (221) for writing a first datum to said first memory; a second data writer (223) for writing a second datum to said second memory; and
an output driver (231) for reading said first datum from said first memory and said second datum from said second memory, and for outputting at least one of said first datum and said second datum based on at least one of said control signals.

10. A method for controlling a machine (201) that has six mutually exclusive states, and which machine receives a binary read signal and a binary write signal, said method CHARACTERIZED BY:

(1) entering a first state:

(a) when said machine is in said first state, said read signal is retracted and said write signal is retracted,

(b) when said machine is in said third state, said read signal is retracted and said write signal is asserted,

(c) when said machine is in said fourth state, said read signal is asserted and said write signal is retracted, and

(d) when said machine is in said sixth state, said read signal is retracted and said write signal is retracted;

(2) entering a second state:

(a) when said machine is in said second state, said read signal is retracted and said write signal is retracted,

(b) when said machine is in said third state, said read signal is asserted and said write signal is retracted,

(c) when said machine is in said fourth state, said read signal is retracted and said write signal is asserted, and

(d) when said machine is in said fifth state, said read signal is retracted and said write signal is retracted;

(3) entering a third state:

(a) when said machine is in said first state, said read signal is retracted and said write signal is asserted,

(b) when said machine is in said second state, said read signal is asserted and said write signal is retracted,

(c) when said machine is in said third state, said read signal is retracted and said write signal is retracted,

(d) when said machine is in said fourth state, said read signal is asserted and said write signal is asserted,

(e) when said machine is in said fifth state, said read signal is asserted and said write signal is retracted, and

(f) when said machine is in said sixth state, said read signal is retracted and said write signal is asserted;

(4) entering a fourth state:

(a) when said machine is in said first state, said read signal is asserted and said write signal is retracted,

(b) when said machine is in said second state, said read signal is retracted and said write signal is asserted,

(c) when said machine is in said third state, said read signal is asserted and said write signal is asserted,

(d) when said machine is in said fourth state, said read signal is retracted and said write signal is retracted,

(e) when said machine is in said fifth state, said read signal is retracted and said write signal is asserted, and

(f) when said machine is in said sixth state, said read signal is asserted and said write signal is retracted;

(5) entering a fifth state:

(a) when said machine is in said first state, said read signal is asserted and said write signal is asserted, and

(b) when said machine is in said sixth state, said read signal is asserted and said write signal is asserted; and

(6) entering a sixth state:

(a) when said machine is in said second state, said read signal is asserted and said write signal is asserted, and

(b) when said machine is in said fifth state, said read signal is asserted and said write signal is asserted.

*FIG. 1*

*FIG. 2*

*FIG. 12*

*FIG. 9*

| *FIG. 7* | *FIG. 8* |
|---|---|

| *FIG. 10* |
|---|
| *FIG. 11* |

## FIG. 3

WRITE

DATA-IN

100

FIFO

111

101

113

103

R/W̄-A

121

DATA-OUT-A

123

DATA-IN-A

125

ADDRESS-A

127

RAM BANK A

FIFO
RAM CONTROLLER

105

R/W̄-B

131

DATA-OUT-B

133

DATA-IN-B

135

ADDRESS-B

137

RAM BANK B

115

117

READ

DATA-OUT

FIG. 4

*FIG. 5*

FIG. 6

*FIG. 7*

D1 D2 D3 D4 D5 D6 READ $\overline{READ}$ WRITE $\overline{WRITE}$ CLOCK D3 D2 D1

D1 D2 D3 D4 D5 D6 READ WRITE CLOCK

$D_1$ $D_2$ $D_3$

FIG. 8

EP 0 695 988 A2

# FIG. 10

CLOCK PERIOD

CLOCK

WRITE SIGNAL (LEAD 111)

DATA-IN (BUS 113)

READ SIGNAL (LEAD 115)

DATA-OUT (BUS 117)

LATCH A (LEAD 315)

ADDRESS MUX A (LEAD 313)

ADDRESS A (BUS 127)

DATA-OUT-A (BUS 123)

DATA-IN-A (BUS 125)

EP 0 695 988 A2

FIG. 11

R/W̄-A (LEAD 121)

LATCH B (LEAD 325)

ADDRESS-MUX B (LEAD 323)

ADDRESS B (BUS 137)

DATA-OUT-B (BUS 133)

DATA-IN-B (BUS 135)

R/W̄-B (LEAD 131)

WRITE INCREMENT (LEAD 245)

READ INCREMENT (LEAD 225)

OUTPUT MUX (LEAD 331)

EP 0 695 988 A2